# EUROPEAN PATENT APPLICATION

(11) **EP 4 607 582 A1**
(43) Date of publication of application: **27.08.2025**
(21) Application number: 24159389.6
(22) Date of filing: 23.02.2024
(51) Int. Cl.: H01L 23/31, H01L 23/36, H01L 23/373, H01L 25/07, H01L 23/00, H01L 23/538

(54) **SEMICONDUCTOR MODULE ARRANGEMENT**

(71) Applicant: Infineon Technologies AG, 85579 Neubiberg (DE)
(72) Inventor: BAYER, Christoph, 97776 Eußenheim (DE); ÜBELACKER, David, 59889 Eslohe-Wenholthausen (DE); TREU, Julian, 81543 München (DE); COLVERO SCHITTLER, Andressa, 59469 Niederense (Ense) (DE); HOHLFELD, Olaf, 59581 Warstein (DE); MICHALSKI, Sebastian, 13347 Berlin (DE); PUGATSCHOW, Anton, 59494 Soest (DE)
(74) Representative: Westphal, Mussgnug & Partner, Patentanwälte mbB

(57) **Abstract**

A semiconductor module arrangement comprises a substrate, and at least one semiconductor component arranged on the substrate. Each of the at least one semiconductor component comprises a semiconductor chip having a first and a second electrode, a first metallic layer attached to the first electrode of the semiconductor chip by means of an electrically conducting connection layer, a second metallic layer attached to the second electrode of the semiconductor chip by means of an electrically conducting connection layer, and a dielectrically insulating layer covering surfaces of the semiconductor chip, wherein surfaces of the first and second metallic layers that face away from the semiconductor chip are not covered by the dielectrically insulating layer.

## Description

### TECHNICAL FIELD

The instant disclosure relates to a semiconductor module arrangement, in particular a semiconductor module arrangement comprising one or more semiconductor chips.

### BACKGROUND

Power semiconductor module arrangements often include at least one semiconductor substrate arranged in a housing. A semiconductor arrangement including a plurality of controllable semiconductor elements (e.g., two IGBTs in a half-bridge configuration) or non-controllable semiconductor elements (e.g., arrangements of diodes) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate.

A distance between neighboring controllable or non-controllable semiconductor elements is often comparably large due to thermal requirements, for example. Further, the overall costs of a semiconductor module may be high in order to meet all thermal, electrical and environmental requirements. Testing the individual semiconductor elements is difficult or even not possible at all.

There is a need for a semiconductor module arrangement that is small in size and has increased thermal properties, and an increased environmental stability, and in which the individual semiconductor elements may be easily tested.

### SUMMARY

A semiconductor module arrangement includes a substrate, and at least one semiconductor component arranged on the substrate. Each of the at least one semiconductor component includes a semiconductor chip having a first and a second electrode, a first metallic layer attached to the first electrode of the semiconductor chip by means of an electrically conducting connection layer, a second metallic layer attached to the second electrode of the semiconductor chip by means of an electrically conducting connection layer, and a dielectrically insulating layer covering surfaces of the semiconductor chip, wherein surfaces of the first and second metallic layers that face away from the semiconductor chip are not covered by the dielectrically insulating layer.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 is a cross-sectional view of a semiconductor element of a semiconductor module arrangement according to embodiments of the disclosure.
Figure 3 is a cross sectional view of a semiconductor module arrangement according to embodiments of the disclosure.
Figure 4, including Figures 4A and 4B, schematically illustrates a conventional semiconductor module arrangement (Figure 4A) and a semiconductor module arrangement according to embodiments of the disclosure (Figure 4B).
Figure 5 schematically illustrates a cross-sectional view of a semiconductor element of a semiconductor module arrangement according to further embodiments of the disclosure.
Figure 6 is a cross sectional view of a semiconductor module arrangement according to further embodiments of the disclosure.
Figure 7 is a cross sectional view of a semiconductor module arrangement according to even further embodiments of the disclosure.
Figure 8 is a cross sectional view of a semiconductor module arrangement according to even further embodiments of the disclosure.
Figure 9 is a cross sectional view of a semiconductor module arrangement according to even further embodiments of the disclosure.
Figure 10 is a cross sectional view of a semiconductor module arrangement according to even further embodiments of the disclosure.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable).

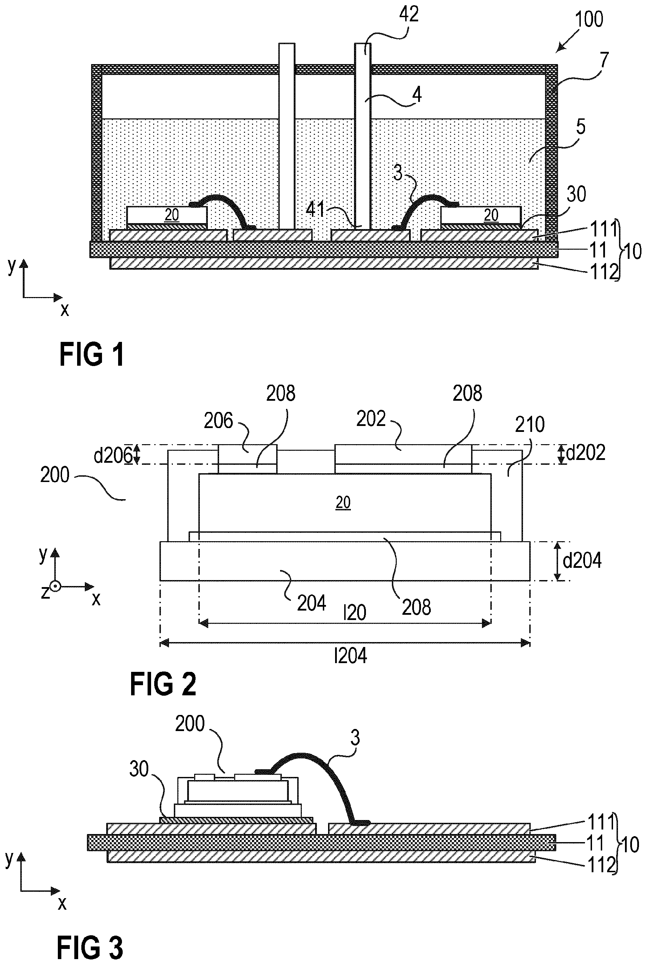

Referring to Figure 1, a cross-sectional view of a power semiconductor module arrangement 100 is illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm.

The substrate 10 is arranged in a housing 7. In the example illustrated in Figure 1, the substrate 10 forms a ground surface of the housing 7, while the housing 7 itself solely comprises sidewalls and a cover. This is, however, only an example. It is also possible that the housing 7 further comprises a ground surface and the substrate 10 be arranged inside the housing 7. According to another example, the substrate 10 may be mounted on a base plate (not illustrated). In some power semiconductor module arrangements 100, more than one substrate 10 is arranged on a single base plate. The base plate may form a ground surface of the housing 7, for example. The top of the housing 7 can either be a separate cover or lid that can be removed from the sidewalls, or may be formed integrally with at least the sidewalls of the housing 7. In the latter case, the top and at least the sidewalls of the housing 7 may be formed as a single piece such that the top cannot be removed from the sidewalls without destroying the housing.

One or more semiconductor bodies 20 may be arranged on the substrate 10. Each of the semiconductor bodies 20 arranged on the substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable or non-controllable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes four different sections. Different semiconductor bodies 20 may be mounted to the same or to different sections of the first metallization layer 111. Different sections of the first metallization layer may have no electrical connection or may be electrically connected to one or more other sections using, e.g., bonding wires 3. Electrical connections 3 may also include connection plates or conductor rails, for example, to name just a few examples. The one or more semiconductor bodies 20 may be electrically and mechanically connected to the semiconductor substrate 10 by an electrically conductive connection layer 30. Such an electrically conductive connection layer may be a solder layer, a diffusion solder layer, a layer of an electrically conductive adhesive, or a layer of a sintered metal powder, e.g., a sintered silver powder, for example.

The power semiconductor module arrangement 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of the terminal elements 4 protrudes out of the housing 7. The terminal elements 4 may be electrically contacted from the outside at their second end 42. The terminal elements 4 illustrated in Figure 1, however, are only examples. Terminal elements 4 may be implemented in any other way and may be arranged at any other position. For example, one or more terminal elements 4 may be arranged close to or adjacent to the sidewalls of the housing 7. Any other suitable implementation is possible. The terminal elements 4 may consist of or include a metal such as copper, aluminum, gold, silver, or any alloys thereof, for example. The terminal elements 4 may be electrically and mechanically connected to the substrate 10 by an electrically conductive connection layer (not specifically illustrated for the terminal elements 4). Such an electrically conductive connection layer generally may be a solder layer, a diffusion solder layer, a layer of an electrically conductive adhesive, or a layer of a sintered metal powder, e.g., a sintered silver powder, for example.

Conventional power semiconductor module arrangements 100 generally further include a casting compound 5. The casting compound 5 may consist of or include a silicone gel or may be a rigid molding compound, for example. The casting compound 5 may at least partly fill the interior of the housing 7, thereby covering the components and electrical connections that are arranged on the substrate 10. The terminal elements 4 may be partly embedded in the casting compound 5. At least their second ends 42, however, are not covered by the casting compound 5 and protrude from the casting compound 5 through the housing 7, to the outside of the housing 7. The casting compound 5 is configured to protect the components and electrical connections inside the power semiconductor module 100, in particular inside the housing 7, from certain environmental conditions and mechanical damage.

The semiconductor bodies 20 arranged on the substrate 10 are usually semiconductor chips that are not separately packaged in any way. That is, they are so-called bare dies. Once the semiconductor arrangement is formed on the substrate 10, the final semiconductor module arrangement may be tested. It is, however, generally not possible to separately test each of the semiconductor chips before arranging them on the substrate 10. Bare-die semiconductor chips generally have to be handled carefully to avoid any damages thereto which might decrease the overall lifetime of the semiconductor module. When arranging the semiconductor chips on the substrate 10, thermal and electrical requirements have to be met. This often results in comparably large distances between neighboring semiconductor chips and, therefore, a comparably large size of the overall semiconductor module. In order to overcome these drawbacks, a semiconductor module arrangement according to embodiments of the disclosure comprises at least one pre-packaged semiconductor chip, which will be described in further detail below.

In particular, a semiconductor module arrangement according to embodiments of the disclosure comprises a substrate 10, and at least one semiconductor component 200 arranged on the substrate 10. Each of the at least one semiconductor component 200 comprises a semiconductor chip 20 having a first and a second electrode. This semiconductor chip 20 corresponds to the semiconductor chips / bodies as used in conventional semiconductor module arrangements. A semiconductor component 200 according to embodiments of the disclosure, however, further comprises a first metallic layer 202 attached to the first electrode of the semiconductor chip 20 by means of an electrically conducting connection layer 208, a second metallic layer 204 attached to the second electrode of the semiconductor chip 20 by means of an electrically conducting connection layer 208, and a dielectrically insulating layer 210 covering surfaces of the semiconductor chip 20, wherein surfaces of the first and second metallic layers 202, 204 that face away from the semiconductor chip 20 are not covered by the dielectrically insulating layer 210. The electrically conducting connection layers 208 may be solder layers, diffusion solder layers, layers of an electrically conductive adhesive, or layers of a sintered metal powder, for example.

That is, the first and second metallic layers 202, 204 allow to electrically contact the first and second electrode, respectively, that are arranged in the package formed by the dielectrically insulating layer 210. The dielectrically insulating layer 210 may be formed by means of a rigid material such as, e.g., a rigid plastic or a ceramic material. The dielectrically insulating layer 210 may be formed in any suitable way, e.g., by means of molding techniques. According to some examples, the material forming the dielectrically insulating layer 210 may be configured to withstand high temperatures, e.g., temperatures of more than 100°C, or more than 200°C. In this way, local temperature stability of the semiconductor module arrangement may be increased.

Referring to Figure 2, a semiconductor component 200 according to further embodiments of the disclosure is schematically illustrated. In this example, the semiconductor chip 20 further comprises a third electrode, and the semiconductor component 200 further comprises a third metallic layer 206 attached to the third electrode of the semiconductor chip 20 by means of an electrically conducting connection layer 208. A surface of the third metallic layer 206 that faces away from the semiconductor chip 20 is not covered by the dielectrically insulating layer 210. In this way, the third electrode may be electrically contacted via the third metallic layer 206. The number of electrodes generally depends on the kind of component formed in the semiconductor chip 20. A diode, for example, generally only has two electrodes (first and second electrode), while an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other kind of transistor generally has at least three electrodes. The general principles similarly apply for semiconductor bodies 20 having two, there, or even more electrodes. One or more semiconductor components 200 may be arranged in a semiconductor module as has been described with respect to Figure 1 above. The semiconductor components 200 may replace the conventional semiconductor bodies (chips) 20, for example.

The first electrode of the semiconductor chip 20 may be arranged on a first side of the semiconductor chip 20 facing away from the substrate 10, and the second electrode of the semiconductor chip 20 may be arranged on a second side of the semiconductor chip 20 opposite the first side and facing towards the substrate 10. If the semiconductor chip 20 comprises a diode, the first electrode may be an anode electrode, and the second electrode may be a cathode electrode, for example. If the semiconductor chip comprises a transistor, the third electrode may be arranged on the same side as the first electrode, i.e. on the first side of the semiconductor chip 20 facing away from the substrate 10. In this case, the first electrode may be a source or emitter electrode, the second electrode may be a drain or collector electrode, and the third electrode may be a gate or base electrode, for example.

The electrodes are generally formed on the semiconductor material of the semiconductor chip by means of comparably thin metallic layers. Such thin metallic layers may have thicknesses of up to 20µm, for example. Wherein a thickness of 20µm is generally considered comparably thick. A greater thickness of the electrodes, however, may be required when they are contacted by comparably thick bonding wires, for example. Forming a semiconductor chip 20 having comparably thick electrodes (e.g., 20µm or even more), however, is usually expensive. Attaching thick metallic layers 202, 204, 206 to the electrodes instead, may significantly reduce the overall costs of a semiconductor component 200.

The first, second and optional third metallic layers 202, 204, 206 may each comprise or consist of copper, or Wolfram or AlSiC or MgSiC or an electrically conductive material with a CTE (coefficient of thermal expansion) of 2 to 17ppm, for example. The first metallic layer 202 and the optional third metallic layer 206 may each have a thickness d202, d206 of between, e.g., 50µm and 300µm in a vertical direction y perpendicular to the first side of the semiconductor chip 20. The second metallic layer 204 may even have a thickness d204 of between 2.0mm and 3.0mm in the vertical direction y. Still referring to Figure 2, the semiconductor chip 20 has a first length l20 in a first horizontal direction x perpendicular to the vertical direction y, and a first width in a second horizontal direction z perpendicular to the first horizontal direction x and the vertical direction y. The second metallic layer 204 has a second length l204 in the first horizontal direction x and a second width in the second horizontal direction z. According to embodiments of the disclosure, a surface area of the second metallic layer 204 defined by the second length l204 and the second width (second surface area = second length * second width) is between 1 and 2 times a surface area of the semiconductor chip 20 defined by the first length l20 and the first width (first surface area = first length * first width).

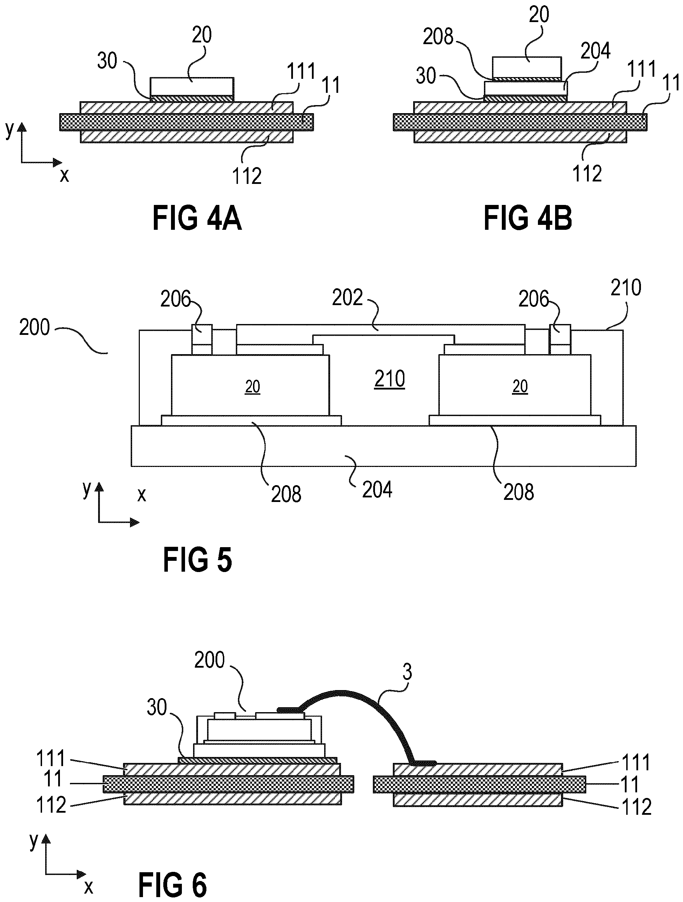

In this way, the second metallic layer 204 may act as a heat spreader. That is, the heat that is generated by the semiconductor chip 20 during operation of the semiconductor module arrangement may be spread over the entire thickness d204 and large cross-sectional area of the second metallic layer 204 before being transferred further to the substrate 10. Due to the comparably large thickness d204 and the large cross-sectional area of the second metallic layer 204, the overall thermal resistance Rth of the semiconductor module arrangement can be significantly decreased (e.g., up to 30% or even more as compared to semiconductor module arrangements including bare die semiconductor chips 20). Figures 4A and 4B schematically illustrate the difference between a bare die semiconductor chip 20 that is directly attached to the substrate 10 (Figure 4A), and a semiconductor component 200 according to embodiments of the disclosure which includes a second metallic layer 204 and an additional electrically conducting connection layer 208 arranged between the semiconductor chip 20 and the substrate 10 (Figure 4B).

The semiconductor components 200 which include a semiconductor chip 20 in a very simple package (formed by the dielectrically insulating layer 210) can be more easily handled as compared to bare dies. Even further, the semiconductor components 200 may be tested separately before arranging them on the substrate 10. That is, any faulty or damaged semiconductor components 200 may be sorted out before the semiconductor module arrangement is even assembled. This significantly increases the overall yield.

The semiconductor components 200, i.e. the metallic layers 202, 204, 206, may be electrically contacted in any suitable way, similar to conventional bare die components. Due to the fact that the packaged semiconductor components 200 are more robust than bare dies, they may even be electrically contacted in additional ways that may not be possible for the more fragile bare dies. As is schematically illustrated in Figure 3, a semiconductor component 200 may be attached and electrically coupled to a substrate 10 by means of an electrically conductive connection layer 30, similar to what has been described with respect to Figure 1 above. An electrically conductive connection layer 30 may be a solder layer, a diffusion solder layer, a layer of an electrically conductive adhesive, or a layer of a sintered metal powder, for example. A semiconductor component 200 may also be electrically connected to further sections of a first metallization layer 111 of a substrate 10 by means of electrical connections 3 such as, e.g., bonding wires, bonding ribbons, connection plates or conductor rails.

Similar to what has been described with respect to the second metallic layer 204 above, a surface area of the first metallic layer 202 may be larger than a surface area of the first electrode of the semiconductor chip 20, and a surface area of the optional third metallic layer 206 may be larger than a surface area of the third electrode of the semiconductor chip 20. In this way, a larger surface area as compared to the bare die semiconductor chips 20 is available for attaching electrical connections 3 or terminal elements 4 thereto, for example.

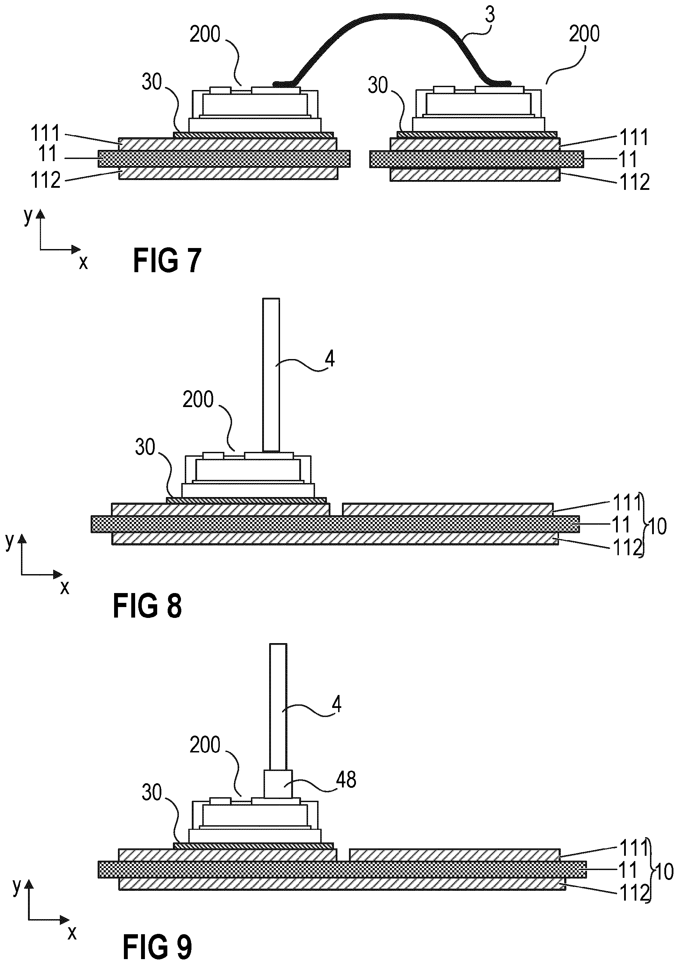

As is schematically illustrated in Figure 6, it is also possible to form connections between different substrates 10. That is, a semiconductor component 200 may be electrically coupled to a first metallization layer 111 of another substrate 10 by means of an electrical connection 3. Referring to Figure 7, it is also possible that a first semiconductor component 200 arranged on a first substrate 10 be electrically coupled to a second semiconductor component 200 arranged on a second substrate 10 by means of an electrical connection 3. The second semiconductor component 200, alternatively, could also be arranged on the same substrate 10 as the first semiconductor component 200.

As the first metallic layer 202 and the optional third metallic layer 206 are comparably thick and therefore robust, it is even possible to arrange terminal elements 4, as have been described with respect to Figure 1 above, directly on the first or third metallic layers 202, 206. This is schematically illustrated in Figure 8, for example. A terminal element 4 could be attached to a respective metallic layer 202, 206 by means of an electrically conductive connection layer (electrically conductive connection layer not specifically illustrated in Figure 8). Referring to Figure 9, it is even possible to arrange a sleeve or bushing 48 on the respective metallic layer (e.g., first metallic layer 202, or third metallic layer 206). A terminal element 4 may then be inserted in the sleeve or bushing.

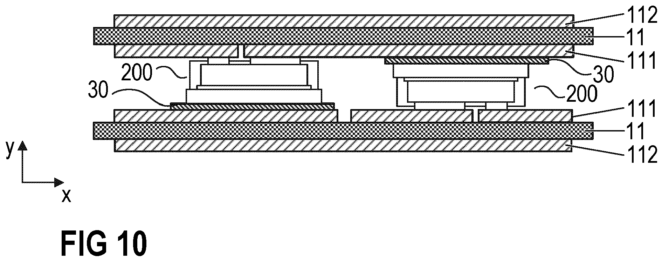

It is even possible, as is schematically illustrated in Figure 10, that the first metallic layer 202 and the optional third metallic layer 206 be directly attached to another substrate 10. That is, one or more semiconductor components 200 may be sandwiched between two substrates 10. The first and the optional third metallic layers 202, 206 may be attached to respective sections of a first metallization layer 111 of a second substrate 10 by means of an electrically conductive connection layer (not specifically illustrated in Figure 10 for the first and third metallic layers 202, 206) as has been described with respect to the second metallic layer 204. As is illustrated in Figure 10, more than one semiconductor component 200 may be sandwiched between the two separate substrate 10. It is also possible that one or more semiconductor components 200 be arranged between the two substrates 10 "upside down", as is schematically illustrated in Figure 10, right hand side. That is, one or more semiconductor components 200 may be attached to the second substrate 10 with their respective second metallic layers 204, and to the first substrate 10 with their first and optional third metallic layers 202, 206.

A semiconductor module arrangement may generally also be implemented in any other suitable way. A substrate 10 with the one or more semiconductor components 200 arranged thereon may finally be arranged in or form a base surface of a housing 7, similarly to what has been described with respect to Figure 1 above. The semiconductor housing 7 may be at least partly filled with a casting compound 5, similar to what has been described with respect to Figure 1 above.

Now referring to Figure 5, a single semiconductor component 200 may even comprise more than one semiconductor chip 20. In the example illustrated in Figure 5, the semiconductor component 200 comprises two semiconductor chips 20. For example, each of a plurality of semiconductor chips 20 may comprise a diode, or each of a plurality of semiconductor chips 20 may comprise a transistor. A semiconductor component 200, therefore, may comprise two or even more diodes or two or even more transistors coupled in parallel to each other, for example. To achieve this, the first metallic layer 202 may not only be attached and electrically coupled to the first electrode of the first semiconductor chip 20, but also to the first electrode of the second semiconductor chip 20 (and any further semiconductor chips included in the semiconductor component 200). Similarly, the second metallic layer 204 may not only be attached and electrically coupled to the second electrode of the first semiconductor chip 20, but also to the second electrode of the second semiconductor chip 20 (and any further semiconductor chips included in the semiconductor component 200).

In the first horizontal direction x, the first semiconductor chip 20 and the second semiconductor chip 20 (and any further semiconductor chips 20) may be spaced apart from each other. A gap formed between the first semiconductor chip 20 and the second semiconductor chip 20 (and any further semiconductor chips 20) in the first horizontal direction x may be filled by the dielectrically insulating layer 210, as schematically illustrated in Figure 5.

## Claims

1. A semiconductor module arrangement comprises:
a substrate (10); and
at least one semiconductor component (200) arranged on the substrate (10),
wherein each of the at least one semiconductor component (200) comprises:
a semiconductor chip (20) having a first and a second electrode,
a first metallic layer (202) attached to the first electrode of the semiconductor chip (20) by means of an electrically conducting connection layer (208),
a second metallic layer (204) attached to the second electrode of the semiconductor chip (20) by means of an electrically conducting connection layer (208), and
a dielectrically insulating layer (210) covering surfaces of the semiconductor chip (20), wherein surfaces of the first and second metallic layers (202, 204) that face away from the semiconductor chip (20) are not covered by the dielectrically insulating layer (210).

2. The semiconductor module arrangement of claim 1, wherein the substrate (10) comprises a dielectric insulation layer (11) and a first metallization layer (111) attached to the dielectric insulation layer (11), and wherein the at least one semiconductor component (200) is arranged on a surface of the first metallization layer (111) that faces away from the dielectric insulation layer (11).

3. The semiconductor module arrangement of claim 2, wherein the dielectric insulation layer (11) is a ceramic layer.

4. The semiconductor module arrangement of any of the preceding claims, wherein
the first electrode of the semiconductor chip (20) is arranged on a first side of the semiconductor chip (20) facing away from the substrate (10), and
the second electrode of the semiconductor chip (20) is arranged on a second side of the semiconductor chip (20) opposite the first side and facing towards the substrate (10).

5. The semiconductor module arrangement of any of the preceding claims, wherein
the first metallic layer (202) has a thickness (d202) of between 50µm and 300µm in a vertical direction (y) perpendicular to the first side of the semiconductor chip (20), and
the second metallic layer (204) has a thickness (d204) of between 2.0mm and 3.0mm in the vertical direction (y).

6. The semiconductor module arrangement of any of the preceding claims, wherein the semiconductor chip (20) of at least one of the at least one semiconductor components (200) further comprises a third electrode, and the respective semiconductor component (200) further comprises a third metallic layer (206) attached to the third electrode of the semiconductor chip (20) by means of an electrically conducting connection layer (208), wherein a surface of the third metallic layer (206) that faces away from the semiconductor chip (20) is not covered by the dielectrically insulating layer (210).

7. The semiconductor module arrangement of claim 6, wherein the third electrode is arranged on a first side of the semiconductor chip (20) facing away from the substrate (10).

8. The semiconductor module arrangement of claim 6 or 7, wherein the third metallic layer (206) has a thickness (d206) of between 50µm and 300µm in a vertical direction (y) perpendicular to the first side of the semiconductor chip (20).

9. The semiconductor module arrangement of any of the preceding claims, wherein the first, second, and third metallic layers (202, 204, 206) each comprise or consist of copper or Wolfram or AlSiC or MgSiC or an electrically conductive material with a CTE of 2 to 17ppm.

10. The semiconductor module arrangement of any of the preceding claims, wherein the electrically conducting connection layers (208) are solder layers, diffusion solder layers, layers of an electrically conductive adhesive, or layers of a sintered metal powder.

11. The semiconductor module arrangement of any of the preceding claims, wherein the semiconductor chip (20) has a first length (l20) in a first horizontal direction (x) perpendicular to the vertical direction (y), and a first width in a second horizontal direction (z) perpendicular to the first horizontal direction (x) and the vertical direction (y),
the second metallic layer (204) has a second length (l204) in the first horizontal direction (x) and a second width in the second horizontal direction (z), and
a surface area of the second metallic layer (204) defined by the second length (l204) and the second width is between 1 and 2 times a surface area of the semiconductor chip (20) defined by the first length (l20) and the first width.

12. The semiconductor module arrangement of any of the preceding claims, wherein each of the at least one semiconductor component (200) is attached to the substrate (10) by means of an electrically conductive connection layer (30).

13. The semiconductor module arrangement of claim 12, wherein each of the at least one electrically conductive connection layer (30) is a solder layer, diffusion solder layer, a layer of an electrically conductive adhesive, or a layer of a sintered metal powder.

14. The power semiconductor module arrangement of any of the preceding claims, wherein
at least one of the at least one semiconductor components (200) further comprises a second semiconductor chip (20) having a first and a second electrode,
the first metallic layer (202) extends from the first electrode of the first semiconductor chip (20) to the first electrode of the second semiconductor chip (20) and is attached to the first electrode of the second semiconductor chip (20) by means of an electrically conducting connection layer (208), and
the second metallic layer (204) extends from the second electrode of the first semiconductor chip (20) to the second electrode of the second semiconductor chip (20) and is attached to the second electrode of the second semiconductor chip (20) by means of an electrically conducting connection layer (208).

15. The power semiconductor module arrangement of claim 14, wherein, in the first horizontal direction (x), the first semiconductor chip (20) and the second semiconductor chip (20) are spaced apart from each other, and wherein a gap formed between the first semiconductor chip (20) and the second semiconductor chip (20) in the first horizontal direction (x) is filled by the dielectrically insulating layer (210).

## Amended claims

### Amended claims in accordance with Rule 137(2) EPC.

1. A semiconductor module arrangement comprises:
a substrate (10); and
at least one semiconductor component (200) arranged on the substrate (10), wherein each of the at least one semiconductor component (200) comprises:
a semiconductor chip (20) having a first and a second electrode,
a first metallic layer (202) attached to the first electrode of the semiconductor chip (20) by means of an electrically conducting connection layer (208),
a second metallic layer (204) attached to the second electrode of the semiconductor chip (20) by means of an electrically conducting connection layer (208), and
a dielectrically insulating layer (210) covering surfaces of the semiconductor chip (20) and forming a molded package, wherein surfaces of the first and second metallic layers (202, 204) that face away from the semiconductor chip (20) are not covered by the dielectrically insulating layer (210).

2. The semiconductor module arrangement of claim 1, wherein the substrate (10) comprises a dielectric insulation layer (11) and a first metallization layer (111) attached to the dielectric insulation layer (11), and wherein the at least one semiconductor component (200) is arranged on a surface of the first metallization layer (111) that faces away from the dielectric insulation layer (11).

3. The semiconductor module arrangement of claim 2, wherein the dielectric insulation layer (11) is a ceramic layer.

4. The semiconductor module arrangement of any of the preceding claims, wherein
the first electrode of the semiconductor chip (20) is arranged on a first side of the semiconductor chip (20) facing away from the substrate (10), and
the second electrode of the semiconductor chip (20) is arranged on a second side of the semiconductor chip (20) opposite the first side and facing towards the substrate (10).

5. The semiconductor module arrangement of any of the preceding claims, wherein
the first metallic layer (202) has a thickness (d202) of between 50µm and 300µm in a vertical direction (y) perpendicular to the first side of the semiconductor chip (20), and
the second metallic layer (204) has a thickness (d204) of between 2.0mm and 3.0mm in the vertical direction (y).

6. The semiconductor module arrangement of any of the preceding claims, wherein the semiconductor chip (20) of at least one of the at least one semiconductor components (200) further comprises a third electrode, and the respective semiconductor component (200) further comprises a third metallic layer (206) attached to the third electrode of the semiconductor chip (20) by means of an electrically conducting connection layer (208), wherein a surface of the third metallic layer (206) that faces away from the semiconductor chip (20) is not covered by the dielectrically insulating layer (210).

7. The semiconductor module arrangement of claim 6, wherein the third electrode is arranged on a first side of the semiconductor chip (20) facing away from the substrate (10).

8. The semiconductor module arrangement of claim 6 or 7, wherein the third metallic layer (206) has a thickness (d206) of between 50µm and 300µm in a vertical direction (y) perpendicular to the first side of the semiconductor chip (20).

9. The semiconductor module arrangement of any of the preceding claims, wherein the first, second, and third metallic layers (202, 204, 206) each comprise or consist of copper or tungsten or AlSiC or MgSiC or an electrically conductive material with a CTE of 2 to 17ppm.

10. The semiconductor module arrangement of any of the preceding claims, wherein the electrically conducting connection layers (208) are solder layers, diffusion solder layers, layers of an electrically conductive adhesive, or layers of a sintered metal powder.

11. The semiconductor module arrangement of any of the preceding claims, wherein the semiconductor chip (20) has a first length (120) in a first horizontal direction (x) perpendicular to the vertical direction (y), and a first width in a second horizontal direction (z) perpendicular to the first horizontal direction (x) and the vertical direction (y),
the second metallic layer (204) has a second length (1204) in the first horizontal direction (x) and a second width in the second horizontal direction (z), and
a surface area of the second metallic layer (204) defined by the second length (1204) and the second width is between 1 and 2 times a surface area of the semiconductor chip (20) defined by the first length (120) and the first width.

12. The semiconductor module arrangement of any of the preceding claims, wherein each of the at least one semiconductor component (200) is attached to the substrate (10) by means of an electrically conductive connection layer (30).

13. The semiconductor module arrangement of claim 12, wherein each of the at least one electrically conductive connection layer (30) is a solder layer, diffusion solder layer, a layer of an electrically conductive adhesive, or a layer of a sintered metal powder.

14. The power semiconductor module arrangement of any of the preceding claims, wherein
at least one of the at least one semiconductor components (200) further comprises a second semiconductor chip (20) having a first and a second electrode,
the first metallic layer (202) extends from the first electrode of the first semiconductor chip (20) to the first electrode of the second semiconductor chip (20) and is attached to the first electrode of the second semiconductor chip (20) by means of an electrically conducting connection layer (208), and
the second metallic layer (204) extends from the second electrode of the first semiconductor chip (20) to the second electrode of the second semiconductor chip (20) and is attached to the second electrode of the second semiconductor chip (20) by means of an electrically conducting connection layer (208).

15. The power semiconductor module arrangement of claim 14, wherein, in the first horizontal direction (x), the first semiconductor chip (20) and the second semiconductor chip (20) are spaced apart from each other, and wherein a gap formed between the first semiconductor chip (20) and the second semiconductor chip (20) in the first horizontal direction (x) is filled by the dielectrically insulating layer (210).
